# EUROPEAN PATENT SPECIFICATION

(11) **EP 3 428 980 B1**
(45) Date of publication and mention of the grant of the patent: **06.05.2020**
(21) Application number: 17425075.3
(22) Date of filing: 14.07.2017
(51) Int. Cl.: H01L 35/08

(54) **A THERMOELECTRIC MODULE**
THERMOELEKTRISCHES MODUL
MODULE THERMOÉLECTRIQUE

(43) Date of publication of application: 16.01.2019
(73) Proprietor: European Thermodynamics Limited, Kibworth, Leicester LE8 0RX (GB); Politecnico Di Torino, 10129 Torino (IT)
(72) Inventor: TULEY, Richard, Kibworth, Leicestershire LE8 0RX (GB); SALVO, Milena, 10129 Torino (IT); PLACHA, Katarzyna, Kibworth, Leicestershire LE8 0RX (GB); SIMPSON, Kevin, Kibworth, Leicestershire LE8 0RX (GB)
(74) Representative: Inchingalo, Simona

(56) References cited:
- WO-A1-2017/098863
- US-A1- 2014 299 170
- US-A1- 2014 305 482

## Description

The present invention relates to thermoelectric devices, in particular thermoelectric devices for energy generation. In particular, the invention relates to a thermoelectric module, e.g. a thermoelectric generator module, and a method of making such a thermoelectric module, e.g. a thermoelectric generator module.

There are many sources of waste heat, for example from automotive and heavy duty vehicle exhausts, industrial processes and shipping. One potential method to recover some of this waste heat as useful electrical power is through thermoelectric generation. Lower temperature thermoelectric modules, typically operating up to around 250°C are widely commercially available, but can have challenges in providing sufficient power at a low enough cost. One method to overcome this is to use thermoelectric modules at higher temperatures, which have the potential for higher power output without significant increases in cost. In order to realise a higher temperature thermoelectric module, a higher temperature bonding technique is required than the conventional soldering process used in devices up to 250°C.

US2013152990 (A1) discloses a solid-liquid interdiffusion bonding structure for a thermoelectric module. This includes coating a silver, nickel, or copper layer on surfaces of a thermoelectric component and an electrode plate, and then coating a tin layer. A thermocompression treatment is performed on the thermoelectric component and the electrode plate, such that the melted tin layer reacts with the silver, nickel, or copper layer to form a silver-tin intermetallic compound, a nickel-tin intermetallic compound, or a copper-tin intermetallic compound.

WO2016075185 (A1) discloses a solid-liquid interdiffusion bonding concept in combination with use of an adhesion layer/diffusion barrier layer/adhesion layer structure (inter-changeably also termed as the ADA structure) in-between the solid-liquid interdiffusion bonding layers and the semiconducting thermoelectric material.

CN105826459 (A) discloses an electrode matching a Cu₂Se-based thermoelectric material and a connection technology thereof. The electrode is a mixture of Ni-A1 alloy and metal elementary substance Al, wherein the mass percentage of metal elementary substance Al is 40-60%, with the balance being Ni-Al alloy. The electrode and the Cu₂Se-based thermoelectric material are connected by discharge plasma sintering, wherein a gradient transition layer is arranged between the electrode and the thermoelectric material.

For a thermoelectric module with a maximum operating temperature > 250°C, a bonding process is required that can withstand higher temperatures, while maintaining a low electrical contact resistance, high mechanical strength and good thermal stability. Conventional brazing techniques (e.g. silver based) typically require >700°C for brazing of the devices. US2013152990 (A1) describes how this can be challenging due to the thermal stress produced upon cooling to room temperature. One alternative is to use a transient liquid phase bonding (TLPB) also called solid-liquid interdiffusion (SLID) bonding. This method uses a material with a melting point T₁, which when a bonding temperature greater than 0.8 T₁ is applied, diffuses into a second material which has a melting point greater than T₁ to form an intermetallic with a melting point > T₁. The resulting joint therefore has the potential to withstand higher temperatures than the bonding temperature.

An additional challenge for several thermoelectric materials, is that the material, and/or the interface formed may not be stable at high bonding temperatures, leading to poor electrical contact resistances. Therefore, it is desirable to lower the bonding temperature without lowering the operating temperature, whilst maintaining high thermal stability. Tin-based TLPB bonding, as described in US2013152990 (A1) successfully lowers the bonding temperature due to tin's low melting point of ∼232 °C. However its thermal stability may not be guaranteed, as for example any residual tin may cause issues since the operation temperature can be above the melting point of the tin. WO2016075185 (A1) uses an additional diffusion barrier in order to improve the thermal stability.

US 2014/305482 A1 (TOHEI TOMOTAKE [JP] ET AL) 16 October 2014 (2014-10-16) relates to a thermoelectric module in which junction reliability is enhanced between a thermoelectric element and an electrode. The thermoelectric module comprises a stress relaxation electrode produced in the form of woven fabric or nonwoven fabric using metallic fiber of aluminum, for example. WO 2017/098863 A1 (HITACHI CHEMICAL CO LTD [JP]) 15 June 2017 (2017-06-15) relates to a thermoelectric conversion module comprising a thermo-element that is connected through a joining layer of aluminum, nickel and titanium and another layer of a nickel component.

According to a first aspect of the present invention there is provided a method for bonding a thermoelectric element to an electrical interconnect, the method comprising: providing a thermoelectric element having a first layer thereon, the first layer being metallic and having a melting point T1; providing (i) an electrical interconnect having a melting point T2; applying a third layer, and stacking the thermoelectric element and the electrical interconnect together so that the third layer is disposed (i) between the first layer and the electrical interconnect, the third layer being metallic, having a melting point T3, comprising at least 90at% aluminium and having a thickness of at least 10µm and up to 50µm; wherein the melting point T3 is lower than the melting point T1 and the melting point T2; performing a heat treatment employing a temperature that is less than the temperature T3, wherein at least 95at% of the aluminium from the third layer reacts with the first layer and the electrical interconnect to form one or more intermetallic compounds; applying a pressure of up to 10 MPa in addition to the heat treatment; and cooling the intermetallic compound(s) such that the thermoelectric element and the electrical interconnect are bonded together.

A further aspect of the invention relates to a method for bonding a thermoelectric element to an electrical interconnect, the method comprising: providing a thermoelectric element having a first layer thereon, the first layer being metallic and having a melting point T1; providing an electrical interconnect having a second layer thereon, the second layer being metallic and having a melting point T2; applying a third layer, and stacking the thermoelectric element and the electrical interconnect together so that the third layer is disposed between the first layer and the second layers, the third layer being metallic, having a melting point T3, comprising at least 90at% aluminium and having a thickness of at least 10µm and up to 50µm; wherein the melting point T3 is lower than the melting point T1 and the melting point T2; performing a heat treatment employing a temperature that is less than the temperature T3, wherein at least 95at% of the aluminium from the third layer reacts with the first layer and the electrical interconnect to form one or more intermetallic compounds; applying a pressure of up to 10 MPa in addition to the heat treatment; and cooling the intermetallic compound(s) such that the thermoelectric element and the electrical interconnect are bonded together.

In this invention we propose the use of aluminium-based diffusion bonding, or transient liquid phase bonding (TLPB), to bond a thermoelectric element to an electrical interconnect (or vice versa). These methods, in particular TLPB, may allow the manufacture of a thermoelectric device (e.g. a thermoelectric generator module) for operation at higher temperatures, and therefore higher power output.

The bonding enables the creation of one or more intermetallic compounds with higher melting points than the melting point of aluminium (∼660 °C), improving the thermal stability of the joint over using aluminium alone. In the context of the present invention an aluminium intermetallic compound is a compound comprising aluminium and another metal.

In embodiments, at least 95at% of the aluminium is incorporated into the intermetallic compound(s).

By using aluminium, under the operating temperature of less than 600 °C, any residual aluminium (which may be less than 5% of the starting aluminium) will still be solid, improving the stability of the joint. The method of the invention allows the operating temperature of the resulting thermoelectric device to be higher (e.g. in comparison with a thermoelectric device manufactured using tin-based diffusion bonding or TLPB) without requiring a high bonding temperature.

The electrical interconnect optionally has the second layer thereon. The second layer is not essential if the electrical interconnect has the required melting point. Even if the second layer is not essential, it may still be preferable. For example, the second layer may be selected for its chemical stability (e.g. oxidation at elevated temperatures) and how stable it is to diffusion (e.g. copper is often quite mobile). In embodiments the electrical interconnect may comprise or consist of copper and the electrical interconnect has a second layer thereon, wherein the second layer does not comprise copper (e.g. a nickel containing second layer).

### The third layer

The third layer may be applied to the first layer and/or to the second layer (or electrical interconnect, e.g. where the second layer is absent).

In embodiments, the third layer may be applied to the first layer.

The third layer may be described as an aluminium layer since it comprises at least 90at% aluminium. The third layer may comprise at least 92at%, at least 95at% or at least 98at% aluminium. Atomic percent (at%) gives the percentage of one kind of atom relative to the total number of atoms. In embodiments, the third layer comprises, or consists essentially of, aluminium or aluminium alloy.

Suitable aluminium alloys may include alloys of aluminium with silicon and/or metals such as copper, magnesium and/or manganese.

In embodiments, the third layer may comprise a foil, a paste or a powder. In one embodiment, the third layer may be an aluminium foil or an aluminium alloy foil.

The third layer has a thickness and the thickness may be measured as the minimum distance from the first layer, through the third layer to the second layer (or the electrical interconnect if the second layer is absent). In embodiments, the third layer has a thickness of at least 10 µm and up to 50µm. It will be understood that the thickness of the third layer is the thickness before the heat treatment is employed.

In embodiments the third layer has a thickness of up to 50µm, 30µm or 20µm and the heat treatment is applied is applied at a temperature of at least 575°C.

In embodiments the third layer has a thickness of up to 50µm, 30µm or 20µm and the heat treatment is applied is applied at a temperature of at least 600°C.

In embodiments the third layer has a thickness of up to 50µm, 30µm or 20µm and the heat treatment is applied is applied at a temperature of no more than 700°C.

In embodiments the third layer has a thickness of up to 50µm, 30µm or 20µm and the heat treatment is applied is applied at a temperature of no more than 650°C.

The amount of aluminium in the third layer may be determined by measurement. Examples of elemental analysis include energy dispersive X-ray spectrometry, X-ray diffraction, spark optical emission spectroscopy, inductively coupled plasma spectroscopy, optical emission spectroscopy, X ray fluorescence spectroscopy, or wet chemical analyses.

It will be understood that the thermoelectric element and the electrical interconnect (also known as an electrode or electrode plate) are stacked so that there is overlap between the third layer and the first layer and overlap between the third layer and the second layer (or the electrical interconnect). The third layer must be in contact with the first and/or second layers (or the electrical interconnect) to allow the reaction to take place. In embodiments at least 70, 80 or 90% of the third layer overlaps with the first layer and/or the second layer (or electrical interconnect). In one embodiment, the entire third layer (100%) overlaps with the first layer and/or the second layer (or electrical interconnect).

### The heat treatment

In embodiments preforming the heat treatment comprises applying heat to the third layer. This may be achieved by using an oven or furnace.

The heat treatment may be performed under an inert atmosphere, e.g. under argon or nitrogen gas.

In embodiments the heat treatment may employ a temperature that is at least 80%, at least 85%, at least 90%, or at least 95% of the melting point temperature T3, both temperatures being measured in degrees Celsius (°C); and/or the heat treatment may employ a temperature that is no more than 150%, 110% or 100% of the temperature T3, both temperatures being measured in degrees Celsius (°C). For example, in one embodiment the heat treatment may employ a temperature that is from 90 to 100% of the temperature T3, such as from 95 to 100% of the temperature T3.

In embodiments, the heat treatment may employ a temperature of at least 525°C, at least 575°C, at least 600°C, at least 625°C or at least 675°C and/or no more than 750°C, no more than 725°C, no more than 675°C, no more than 650°C or no more than 625°C. In one embodiment the heat treatment employs a temperature of from 525°C to 725°C, such as from 600 to 700°C. It will be understood that lower temperatures are better from an economical viewpoint and for reducing stress on the components, but this must be balanced against other factors including achieving a good bond.

In embodiments, the heat treatment is applied for a period of at least 1 minute and/or up to 300 minutes. The heat treatment may be applied for at least 2 minutes or at least 3 minutes. The heat treatment may be applied for up to 60 minutes, up to 120 minutes or up to 240 minutes.

In embodiments, pressure is applied in addition to the heat treatment. Pressure may be applied simultaneously with the heat treatment for some or all of the heat treatment period. For instance, the heat treatment may be a thermocompression treatment, i.e. compression is applied together with the heat treatment. In embodiments, the thermocompression treatment is performed under a pressure of at least 0.1MPa, 0.5MPa, 1.0MPa, 5MPa and/or up to 1, 5 or 10MPa, such as at least 1 MPa and/or up to 5 MPa. In embodiments, the thermocompression treatment may be performed under a pressure of at least 0.1 MPa and/or up to 10 MPa at a temperature of at least 525°C and/or up to 700°C. The thermocompression treatment may comprise a pressure of at least 0.5MPa and/or up to 5MPa at a temperature of at least 600°C and/or up to 650°C for a period of at least 2 minutes and/or up to 120 minutes.

It will be understood that pressure may be applied to bring the thermoelectric element and the electrical interconnect together. Pressure may be applied by placing the components in a jig (e.g. a clamp or vice). The pressure is therefore unidirectional.

In one embodiment the thermoelectric element and the electrical interconnect may be stacked together within a clamp so that the third layer is disposed therebetween. The clamp can be tightened to achieve the desired pressure.

### The intermetallic compound(s)

The intermetallic compound or compounds comprise aluminium. The resulting intermetallic compound(s) will vary depend on the metal(s) present in the first layer and the second layer (or electrical interconnect), which metal(s) may include for example nickel, silver, gold, copper or titanium.

In embodiments, the aluminium from the third layer reacts to form one or more intermetallic compounds selected from intermetallic compounds of aluminium with nickel, silver, gold, copper or titanium, for example Al₃Ni, Al₃Ni₂, AINi, Al₃Ni₅, AlNi₃, Al₂Aᵤ, AlAu, AlAu₂, AlAu₄, Al₂Ag, CuAl₂, Al₃Ti or combinations of the above.

In embodiments the aluminium may react with the first layer to form one or more intermetallic compounds. In embodiments the aluminium may react with the second layer to form one or more intermetallic compounds. In embodiments where the second layer is absent the aluminium may react with the electrical interconnect to form one or more intermetallic compounds. In embodiments the aluminium may react with the first layer and the second layer to form one or more intermetallic compounds. In embodiments the aluminium may react with the first layer and the electrical interconnect to form one or more intermetallic compounds.

The aluminium in the third layer may partially react to form one or more intermetallic compounds. In one embodiment at least 80, 90 or 95at% of the aluminium in the third layer reacts to form one or more intermetallic compounds. The aluminium in the third layer may substantially completely react to form one or more intermetallic compounds i.e. the aluminium in the third layer may be substantially consumed following the heat treatment.

The extent of reaction can be determined by analysis of the third layer before and after the heat treatment is performed. Examples of elemental analysis include energy dispersive X-ray spectrometry, X-ray diffraction, spark optical emission spectroscopy, inductively coupled plasma spectroscopy, optical emission spectroscopy, X-ray fluorescence spectroscopy, or wet chemical analyses.

### The first and second layers

The first layer may comprise the same material as the second layer or a different material from the second layer. In embodiments, the first layer and the second layer comprise the same material.

The first layer and/or the second layer may comprise, or consist essentially of, nickel, Ni-P, Ni-B, Ni-P-W, Ni-Cu-P, Ni-P-Ag, Ni-B-P, electroless nickel compositions, nickel ternary and quaternary alloys, nickel-phosphorus or nickel-boron composites, gold, silver, copper and titanium and their ternary and quaternary alloys or combinations of the above.

In embodiments, the first layer and/or the second layer may comprise, or consist essentially of, nickel or a nickel alloy. In one such embodiment the first layer and/or the second layer comprises, or consists essentially of, nickel, Ni-P, Ni-B, Ni-P-W, Ni-Cu-P, Ni-P-Ag, Ni-B-P, electroless nickel compositions, nickel ternary and quaternary alloys, nickel-phosphorus or nickel-boron composites.

In embodiments, the first layer and/or the second layer comprises, or consists essentially of, gold, silver, copper and titanium and their ternary and quaternary alloys. In one such embodiment the first layer and/or the second layer comprises, or consists essentially of, gold and/or titanium.

In embodiments the method comprises an initial step of applying the first layer to the thermoelectric element and/or an initial step of applying the second layer to the electrical interconnect.

In embodiments the first layer and/or the second layer may be applied (e.g. deposited) by sputtering, electrolytic plating, electroless plating, thermal spraying, thermal evaporation, electron-beam evaporation or by prior diffusion bonding of a foil to the electrical interconnect or thermoelectric element respectively.

In embodiments the first layer and/or the second layer has a thickness of at least 0.5 µm and/or up to 200 µm. The first layer and/or the second layer may have a thickness of at least 1 µm, at least 2 µm, at least 5µm, at least 10µm or at least 15 µm. The first layer and/or the second layer may have a thickness of up to 100 µm, up to 50 µm, up to 30 µm, up to 15 µm, or up to 10 µm. It will be understood that the thickness of the first and second layers is the thickness before the heat treatment is employed.

### Thermoelectric element and electrical interconnect

The electrical interconnect may have an electrical conductivity greater than the thermoelectric material. The electrical interconnect may comprise, or consist essentially of, a metal, for example copper, molybdenum, silver, nickel, titanium or iron.

In embodiments where the electrical interconnect has a second layer thereon, the second layer may be different from the electrical interconnect. For example, the electrical interconnect may comprise, or consist essentially of, copper and the second layer may comprise, or consist essentially of, nickel or nickel alloy. Advantageously, the use of a nickel layer on the electrical interconnect, e.g. a copper electrical interconnect, can protect against corrosion.

In one embodiment the electrical interconnect may comprise, or consist essentially of, nickel or nickel alloy and therefore no second layer may be required; the aluminium can react directly with the nickel of the electrical interconnect to form an Al-Ni intermetallic compound.

The thermoelectric element may comprise:
a body comprising, or consisting essentially of, a thermoelectric material, the body having:
a first heat transfer face and a second heat transfer face, wherein the first heat transfer face and the second heat transfer faces are opposing planar faces;
one or more principal lateral faces, each principal lateral face extending between the first heat transfer face and the second heat transfer face.

As such, the first heat transfer face and/or the second heat transfer face may have the first layer thereon.

The thermoelectric element may comprise a p-type thermoelectric material or an n-type thermoelectric material. Suitable thermoelectric materials for the thermoelectric element(s) may include, but are not limited to: bismuth telluride; bismuth selenide; antimony telluride; lead telluride; lead selenide; magnesium silicide; magnesium stannide; higher manganese silicide; skutterudite materials; Half Heusler alloys; silicon-germanium, oxides and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

In embodiments, the thermoelectric element comprises, or consists essentially of, (i) skutterudite materials; or (ii) silicides.

According to a second aspect of the invention there is provided a bonding structure comprising a thermoelectric element and an electrical interconnect having a bonding layer disposed therebetween so as to bond the thermoelectric element and the electrical interconnect together, the bonding layer comprising one or more aluminium intermetallic compounds.

The bonding structure of the second aspect may be obtained or obtainable by the method of the first aspect and the comments above apply equally to the second aspect.

The aluminium intermetallic compound(s) may comprise intermetallic compounds of aluminium with nickel, silver, gold, copper or titanium. In embodiments the intermetallic compounds comprise Al₃Ni, Al₃Ni₂, AINi, Al₃Ni₅, AlNi₃, Al₂Au, AlAu, AlAu₂, AlAu₄, Al₂Ag, CuAl₂, Al₃Ti or combinations of the above.

In embodiments at least 90at%, at least 95at%, at least 98at%, at least 99at% or 100at% of the aluminium present in the bonding layer is present in the form of aluminium intermetallic compound(s). In other words, no more than 10at% of the aluminium is "free" to diffuse through the bonding layer, which could provide a problem over the lifetime of a product such as a thermoelectric module including the bonding structure, which is intended to operate at elevated temperatures for a long time.

The bonding layer may be a graded layer, such that the total concentration of the aluminium varies from the thermoelectric element to the electrical interconnect. The concentration of aluminium is likely to be greatest towards the middle of the bonding layer and least adjacent the thermoelectric element and the electrical interconnect.

The bonding layer may comprise a metallic layer in contact with the thermoelectric element and/or a metallic layer in contact with the electrical interconnect. This metallic layer may be a residual layer from the first layer/second layer employed in its method of manufacture.

In embodiments the bonding layer comprises a metallic layer in contact with the thermoelectric element and/or in contact with the electrical interconnect, wherein the metallic layer comprises or consists of nickel, Ni-P, Ni-B, Ni-P-W, Ni-Cu-P, Ni-P-Ag, Ni-B-P, electroless nickel compositions, nickel ternary and quaternary alloys, nickel-phosphorus or nickel-boron composites, gold, silver, copper and titanium and their ternary and quaternary alloys or combinations of the above.

In embodiments the bonding layer comprises an aluminium intermetallic layer that is disposed adjacent at least one metallic layer, e.g. between two metallic layers.

In embodiments the bonding layer has a thickness of at least 1 µm and/or up to 200 µm. The bonding layer may have a thickness of at least 2 µm, at least 3 µm or at least 5 µm. The bonding layer may have a thickness of up to 200 µm, up to 100 µm or up to 50 µm. It will be understood that the thickness of the bonding layer is the thickness after the heat treatment of the first aspect has been employed.

According to a third aspect of the present invention there is provided a thermoelectric module, e.g. a thermoelectric generator module comprising one or more bonding structures of the second aspect.

It will be understood that the bonding structures will be connected in series. By connecting an n-type and a p-type semiconductor electrically in series and thermally in parallel, the thermal voltage across each element adds. This principle is applied in thermoelectric modules comprising many such n-type and p-type thermoelectric elements to increase the thermoelectric power generation.

The thermoelectric module (e.g. thermoelectric generator module) may comprise at least 8, at least 14, at least 70, at least 140, at least 200, at least 350, at least 400, at least 500, at least 600, at least 700, or at least 800 of the bonding structures and/or no more than 900, 700, 500, 400, 300, 200 or 100 of the bonding structures. In embodiments the thermoelectric generator module comprises from 140 to 350 bonding structures.

The thermoelectric module (e.g. thermoelectric generator module) may comprise a substrate on which the bonding structures are mounted. Typically, a pair of substrates are employed and the bonding structures are mounted between the substrates. The or each substrate may be a ceramic substrate. An example of a suitable material used for the ceramic substrate(s) is aluminium oxide or aluminium nitride.

According to a fourth aspect of the present invention there is provided a thermoelectric device comprising one or more thermoelectric modules of the third aspect.

The thermoelectric device may comprise at 2, 5, 10 or 20 thermoelectric modules of the third aspect.

A heat recovery system utilising a thermoelectric generator module according to the invention may be arranged to recover heat, in use, from an exhaust or heat exchanger (radiator) of a vehicle such as a car, a lorry or a bus. Heat recovery systems utilising a thermoelectric device comprising one or more thermoelectric generator modules according to the invention may also be used in non-automotive applications, for example, marine applications, non-terrestrial applications (e.g. satellites and spacecraft), oil and gas, industrial waste heat recovery (e.g. chimneys) and remote sensing.

According to a fifth aspect of the present invention there is provided a use of a thermoelectric module according to the third aspect or a thermoelectric device according to the fourth aspect to generate electrical power or to provide cooling.

An advantage of the thermoelectric module or thermoelectric device of the present invention is that is can be operated at higher temperatures than conventional modules. In embodiments the thermoelectric generator module may be operated at a temperature of up to or at least 300°C, 350°C, 400°C, 450°C, 500°C, 550°C, 600°C, 650°C and/or no more than 1200°C, 1000°C, 800°C or 600°C. In one embodiment the module is operated at a temperature of from 300 to 600°C or from 350 to 500°C.

Embodiments of the invention will now be described with reference to the following figures in which:
Figure 1 is a schematic representation of a conventional thermoelectric module;
Figure 2 is a schematic representation of a conventional thermoelectric module with the hot side ceramic not shown for clarity.
Figure 3 is a schematic representation showing the details of the joints in an embodiment of the invention before bonding has occurred.
Figure 4 is a schematic representation showing the details of the joints in an embodiment of the invention after bonding has occurred.
Figure 5 is a scanning electron microscope image of a joint in accordance with an embodiment of the invention after bonding.
Figure 6 is a graph demonstrating the measured aging behaviour of transient liquid phase bonding compared to diffusion bonding.

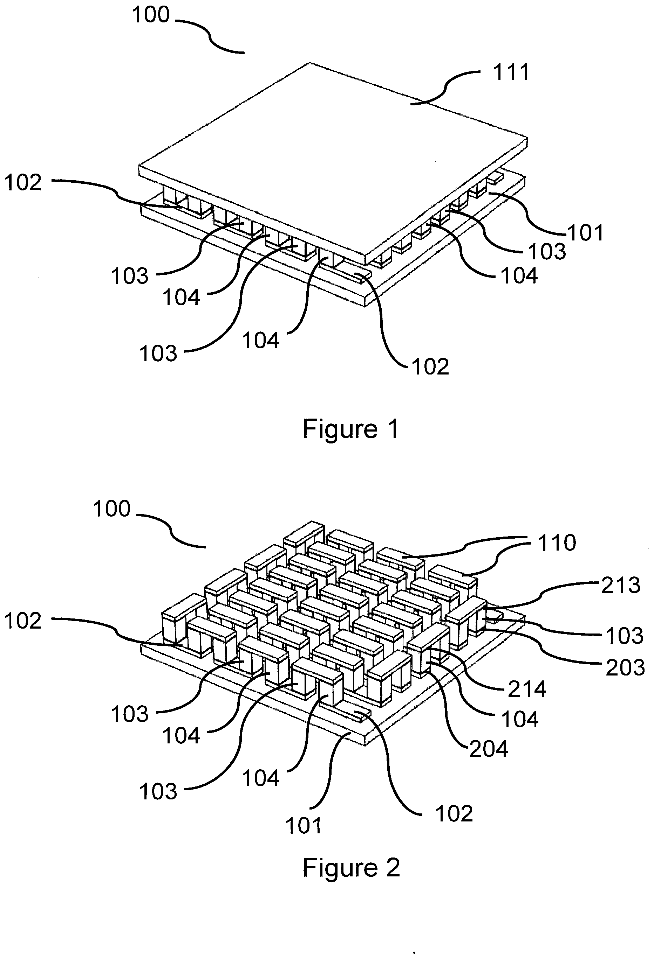

A standard thermoelectric module 100 as is well known in the prior art is shown in Figures 1 and 2. The thermoelectric module 100 comprises a bottom substrate 101, electrical interconnects 102 disposed on the bottom substrate 101, alternating n-type thermoelectric elements 104 and p-type thermoelectric elements 103, and electrical interconnects 110 disposed on the top substrate 111. The electrical interconnects 102 and 110 connect the n-type 104 and p-type 103 thermoelectric elements in series, thereby forming a string of electrically connected thermocouples. The n-type and p-type thermoelectric elements are connected to the electrical interconnects 102 by joints 204 and 203 respectively. The n-type and p-type thermoelectric elements are connected to the electrical interconnects 110 by joints 214 and 213 respectively

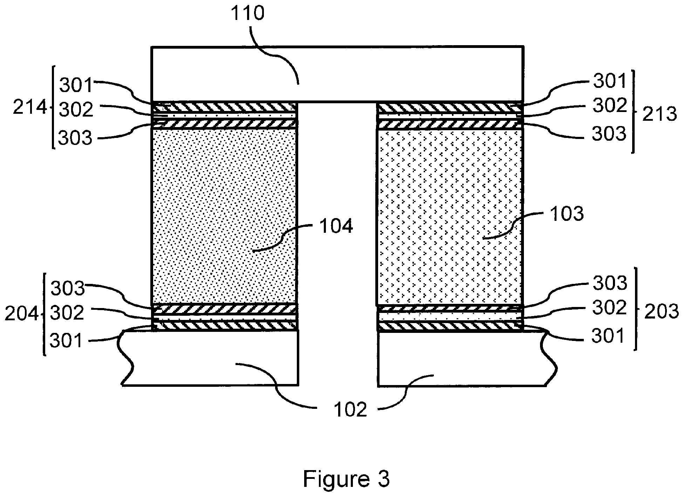

An embodiment of the invention before bonding is shown in figure 3. Each joint 203, 204, 213, 214 comprises a layer of material 303 adjacent to the thermoelectric element, a layer of material 301 adjacent to the electrical interconnect 102, 110, and an aluminium layer 302 of aluminium or an alloy with minimum 90 at% of aluminium content, in the form of a powder, foil or disposed by any possible coating process between layers 301 and 303. Layers 301 and 303 are formed of materials with a higher melting point than the aluminium of layer 302. In this description joints 203, 204, 213 and 214 are detailed with identical layers, but different joints may have different materials as for example the module assembly process may be performed in several stages, and the requirements for the n-type and p-type materials, and the top and bottom substrates may differ.

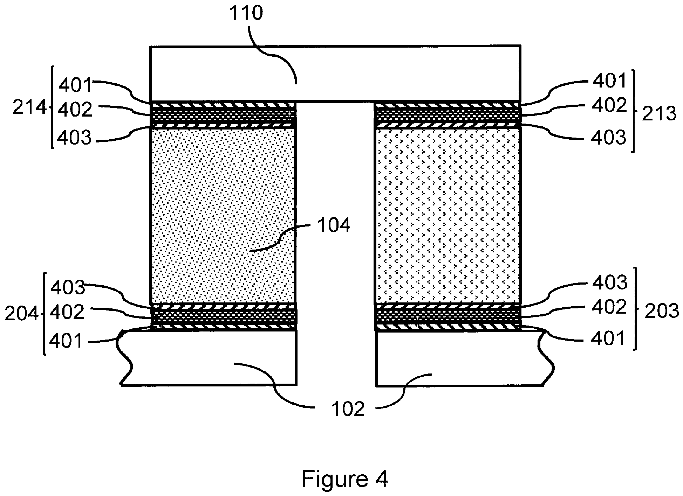

After the bonding process, the joints are as displayed in figure 4. The aluminium has diffused into at least one of layers 301 and 303 to form an intermetallic layer 402. This has led to a thinning of at least one of the layers 301 and 303 to their final form 401 and 403. Typically, at least 95% of the aluminium is incorporated into an intermetallic compound.

More than one intermetallic layer may form between the layers 401 and 403.

Intermetallic layers may additionally form between the electrical interconnect 102, 110 and the layer of material 301 during the bonding process.

Intermetallic layers may additionally form between the thermoelectric material 103, 104 and the layer of material 303 during the bonding process.

At least one of layer 301 or 303 may comprise nickel, Ni-P, Ni-B, Ni-P-W, Ni-Cu-P, Ni-P-Ag, electroless nickel compositions, nickel ternary and quaternary alloys, nickel-phosphorus or nickel-boron composites, gold, silver, copper and titanium and their ternary and quaternary alloys or combinations of the above.

Layers 301 and 303 may be deposited by sputtering, electrolytic or electroless plating, thermal spraying, thermal evaporation, electron-beam evaporation or by prior diffusion bonding of a foil to the electrical interconnect or thermoelectric element respectively.

Layers 301 and 303 may comprise the same material.

Layer 301 and 303 may have different thicknesses. Layer 303 may be thicker than 301, such that the thickness of layer 403 is minimised after bonding. By minimising the thickness of layer 401 after bonding, it may reduce any reduction in thermal stability due to the interaction between layer 401 and the thermoelectric element.

The intermetallic layer 402 may comprise more than one intermetallic compound.

Depending on the composition of layers 301, 303, the intermetallic layer 402 may for example comprise intermetallic compounds of aluminium with nickel, silver, gold, copper or titanium, for example Al₃Ni, Al₃Ni₂, AINi, Al₃Ni₅, AlNi₃, Al₂Au, AlAu, AlAu₂, AlAu₄, Al₂Ag, CuAl₂, Al₃Ti or combinations of the above.

Typically, the bonding process may require an applied temperature greater than 0.8 of the melting point of aluminium. In one embodiment, the applied temperature may be greater than 0.95 of the melting point of aluminium. The applied temperature may be less than 1.1 of the melting point of aluminium. In an embodiment, during the bonding process pressure is applied to the joint in addition to the applied temperature. Compression may be applied to the joint in addition to the applied temperature.

The aluminium layer 302 may comprise a foil, or paste. The aluminium layer may be adhered to one of layers 301 or 303, for example by sputtering onto one of the surfaces.

The aluminium layer 302 may have a thickness in the range of from 1 to 100 microns. The aluminium layer 302 may have a thickness in the range of from 5 to 25 microns.

The layer 301 may have a thickness in the range of from 1 to 100 microns. The layer 301 may have a thickness in the range of from 5 to 25 microns. The layer 303 may have a thickness in the range of from 1 to 100 microns. The layer 303 may have a thickness in the range of from 5 to 25 microns.

The electrical interconnect 102 and 110 may have an electrical conductivity greater than the thermoelectric material. The electrical interconnect may comprise, or consist essentially of, a metal, for example copper, molybdenum, silver, nickel, titanium or iron.

Suitable thermoelectric materials for the thermoelectric elements may include, but are not limited to: bismuth telluride; bismuth selenide; antimony telluride; lead telluride; lead selenide; magnesium silicide; magnesium stannide; higher manganese silicide; skutterudite materials; Half Heusler alloys; silicon-germanium, oxides and combinations of the above. Suitable thermoelectric materials may also include any binary, tertiary or quaternary compound, or any chemical composition, of the above listed elements (or any other elements), that exhibits favourable thermoelectric properties. The thermoelectric material may be crystalline or amorphous. The thermoelectric materials may also include any suitable combination of dopants and/or other additives that may alter the chemical composition and/or thermoelectric properties.

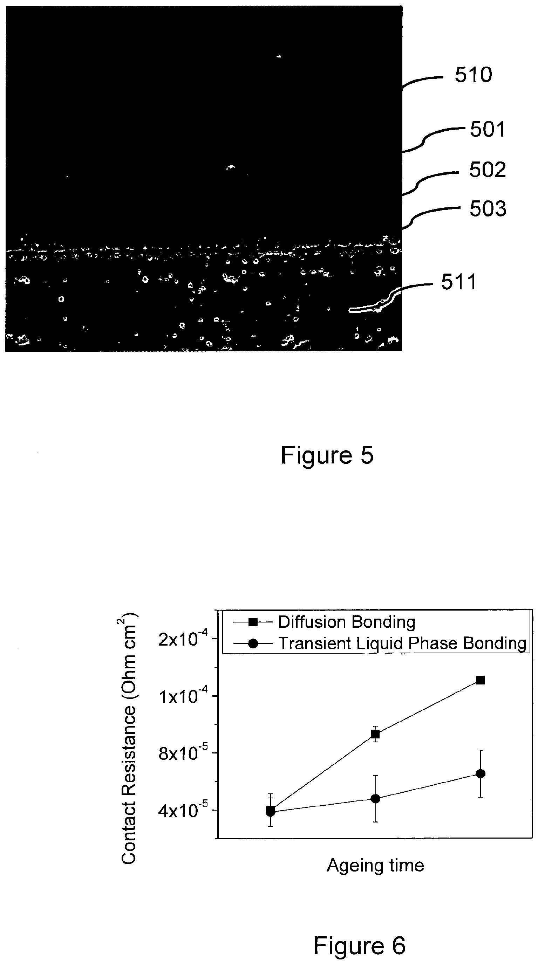

An example of a bonded joint is shown in Figure 5. The thermoelectric material 511 is bonded to an electrical interconnect 510 by an aluminium-nickel intermetallic layer 502 between two nickel-based layers 501 and 503. The aluminium-nickel intermetallic layer 502 has been formed in the bonding process from an aluminium foil and nickel-based layers formed on the electrical interconnect and thermoelectric material respectively. The aluminium foil has been consumed in this process. The bonding process may be considered to have gone to completion, i.e. at least 95% of the aluminium has been incorporated in intermetallic compound(s) formed in the bonding process.

Sufficient mechanical bonding of the thermoelectric element to the electrical interconnect can occur via diffusion bonding, where >5% of the aluminium is left after the bonding process (i.e. >5% of the aluminium has not been incorporated in intermetallic compound(s) formed in the bonding process). However, in contrast to the TLPB process (when at least 95% of the aluminium has been incorporated in intermetallic compound(s) formed in the bonding process), diffusion bonding offers lower thermal stability. In general, the more of the aluminium that is incorporated in intermetallic compound(s) formed in the bonding process, the more thermally stable will be the resulting bond. Aluminium atoms that are not incorporated in the formed intermetallic compound(s) may be relatively mobile, which may adversely affect the thermal stability of the joint over the operational lifetime of a thermoelectric device containing the joint.

This difference in thermal stability is illustrated in Figure 6, where an accelerated aging test indicates that the contact resistance, which it is desirable to minimise, rises with aging. The rise is significantly higher for diffusion bonding than transient liquid phase bonding (TLPB). This indicates that the use of aluminium-based TLPB in the manufacture and/or assembly of thermoelectric devices intended for high temperature operation over long periods of time may be particularly advantageous.

It will be appreciated that the present invention advantageously may be used to produce a thermally stable joint using aluminium-based TLPB without the additional complication and cost of adding a diffusion barrier.

The specific process conditions employed will depend on, among other things, the thickness of the aluminium layer.

Examples of process conditions that have been found to produce good quality, mechanically and thermally stable bonds for use in the manufacture and/or assembly of thermoelectric devices intended for high temperature, typically long lifetime, operation include the following:

### Example 1 (TLPB):

Aluminum foil thickness: 17 µm
Ni-P deposit thickness on copper electrical interconnect: 14 µm
Ni-P deposit thickness on thermoelectric element: 14 µm
Heat treatment: 640°C for 5 minutes
Applied pressure (compression): ∼1.2MPa
Acceptable, although slightly poorer results were obtained using heat treatments of 640°C for 15 minutes and 640°C for 60 minutes.

### Example 2 (diffusion bonded):

Aluminum foil thickness: 17 µm
Ni-P deposit thickness on copper electrical interconnect: 14 µm
Ni-P deposit thickness on thermoelectric element: 14 µm
Heat treatment: 585°C for 15 minutes
Applied pressure (compression): ∼1.2MPa

Thermoelectric devices according to the present invention may be capable of operating at temperatures in excess of 250°C and/or up to 600°C. Accordingly, higher power outputs may be realised, in use, without significant increases in cost.

## Claims

1. A method for bonding a thermoelectric element to an electrical interconnect, the method comprising:
providing a thermoelectric element having a first layer thereon, the first layer being metallic and having a melting point T1;
providing (i) an electrical interconnect having a melting point T2;
applying a third layer, and stacking the thermoelectric element and the electrical interconnect together so that the third layer is disposed (i) between the first layer and the electrical interconnect, the third layer being metallic, having a melting point T3, comprising at least 90at% aluminium and having a thickness of at least 10µm and up to 50µm;
wherein the melting point T3 is lower than the melting point T1 and the melting point T2;
performing a heat treatment employing a temperature that is less than the temperature T3, wherein at least 95at% of the aluminium from the third layer reacts with the first layer and the electrical interconnect to form one or more intermetallic compounds;
applying a pressure of up to 10 MPa in addition to the heat treatment; and
cooling the intermetallic compound(s) such that the thermoelectric element and the electrical interconnect are bonded together.

2. A method for bonding a thermoelectric element to an electrical interconnect, the method comprising:
providing a thermoelectric element having a first layer thereon, the first layer being metallic and having a melting point T1;
providing an electrical interconnect having a second layer thereon, the second layer being metallic and having a melting point T2;
applying a third layer, and stacking the thermoelectric element and the electrical interconnect together so that the third layer is disposed between the first layer and the second layers, the third layer being metallic, having a melting point T3, comprising at least 90at% aluminium and having a thickness of at least 10µm and up to 50µm;
wherein the melting point T3 is lower than the melting point T1 and the melting point T2;
performing a heat treatment employing a temperature that is less than the temperature T3, wherein at least 95at% of the aluminium from the third layer reacts with the first layer and the electrical interconnect to form one or more intermetallic compounds;
applying a pressure of up to 10 MPa in addition to the heat treatment; and
cooling the intermetallic compound(s) such that the thermoelectric element and the electrical interconnect are bonded together.

3. The method of claim 1 or claim 2, wherein the third layer: (i) comprises, or consists essentially of, aluminium or an aluminium alloy selected from alloys of aluminium with silicon, copper, magnesium and/or manganese; and/or (ii) comprises a foil, a paste or a powder.

4. The method of any one of the preceding claims, wherein the heat treatment employs a temperature that is at least 80% of the melting point temperature T3, both the heat treatment temperature and T3 being measured in degrees Celsius (°C).

5. The method of any one of the preceding claims, wherein the heat treatment employs a temperature of at least 525°C and/or the heat treatment is performed for at least 1 minute and/or up to 300 minutes.

6. The method of any one of the preceding claims, wherein: the first layer comprises, or consists essentially of, nickel, Ni-P, Ni-B, Ni-P-W, Ni-Cu-P, Ni-P-Ag, Ni-B-P, electroless nickel compositions, nickel ternary and quaternary alloys, nickel-phosphorus or nickel-boron composites, gold, silver, copper and titanium and their ternary and quaternary alloys or combinations of the above; and/or the method comprises an initial step of applying the first layer to the thermoelectric element; or
the method of claim 2, or any one of claims 3 to 6 when dependent on claim 2, wherein the second layer comprises, or consists essentially of, nickel, Ni-P, Ni-B, Ni-P-W, Ni-Cu-P, Ni-P-Ag, Ni-B-P, electroless nickel compositions, nickel ternary and quaternary alloys, nickel-phosphorus or nickel-boron composites, gold, silver, copper and titanium and their ternary and quaternary alloys or combinations of the above; and/or the method comprises an initial step of applying the second layer to the electrical interconnect.

7. The method of any one of the preceding claims, wherein: the first layer has a thickness of at least 0.5µm and/or up to 200µm; or
the method of claim 2, or any one of claims 3 to 6 when dependent on claim 2, wherein the second layer has a thickness of at least 0.5µm and/or up to 200µm and/or the electrical interconnect comprises, or consists essentially of, copper, and the second layer comprises, or consists essentially of, nickel or a nickel alloy.

8. The method of any one of the preceding claims, wherein the thermoelectric element comprises, or consists essentially of, one or more thermoelectric materials selected from: bismuth telluride; bismuth selenide; antimony telluride; lead telluride; lead selenide; magnesium silicide; magnesium stannide; higher manganese silicide; skutterudite materials; silicides; Half Heusler alloys; silicon-germanium, oxides and combinations of the above.

9. A bonding structure comprising a thermoelectric element and an electrical interconnect having a bonding layer disposed therebetween so as to bond the thermoelectric element and the electrical interconnect together, the bonding layer comprising one or more aluminium intermetallic compounds, wherein at least 90at% of the aluminium present in the bonding layer is present in the form of aluminium intermetallic compound(s) and the bonding layer has a thickness of at least 1µm and up to 200µm.

10. The bonding structure of claim 9, wherein the aluminium intermetallic compounds comprise intermetallic compounds of aluminium with nickel, silver, gold, copper or titanium.

11. The bonding structure of claim 9 or claim 10, wherein the bonding layer comprises a metallic layer in contact with the thermoelectric element and/or a metallic layer in contact with the electrical interconnect.

12. A thermoelectric module or a thermoelectric device comprising one or more bonding structures according to any of claims 9, 10 or 11.

13. A heat recovery system comprising a thermoelectric module or a thermoelectric device according to claim 12.

14. A vehicle comprising a heat recovery system according to claim 13.

15. Use of a thermoelectric module or a thermoelectric device according to claim 12 to generate electrical power or to provide cooling.

## Patentansprüche

1. Verfahren zum Binden eines thermoelektrischen Elements an ein elektrisches Verbindungselement, wobei das Verfahren umfasst:
Bereitstellen eines thermoelektrischen Elements mit einer ersten Schicht darauf, wobei die erste Schicht metallisch ist und einen Schmelzpunkt T1 aufweist;
Bereitstellen (i) eines elektrischen Verbindungselements mit einem Schmelzpunkt T2;
Aufbringen einer dritten Schicht und Aufeinanderstapeln des thermoelektrischen Elements und des elektrischen Verbindungselements, wobei die dritte Schicht (i) zwischen der ersten Schicht und dem elektrischen Verbindungselement angeordnet ist, wobei die dritte Schicht metallisch ist, einen Schmelzpunkt T3 aufweist, wenigstens 90 at-% Aluminium umfasst und eine Dicke von wenigstens 10 µm und bis zu 50 µm aufweist;
wobei der Schmelzpunkt T3 niedriger als der Schmelzpunkt T1 und der Schmelzpunkt T2 ist;
Durchführen einer Wärmebehandlung unter Verwendung einer Temperatur, die niedriger als die Temperatur T3 ist, wobei wenigstens 95 at-% des Aluminiums der dritten Schicht mit der ersten Schicht und dem elektrischen Verbindungselement reagieren, um eine oder mehrere intermetallische Verbindungen zu bilden;
Anwenden eines Drucks von bis zu 10 MPa zusätzlich zu der Wärmebehandlung; und
Abkühlen der intermetallischen Verbindung(en), so dass das thermoelektrische Element und das elektrische Verbindungselement miteinander verbunden werden.

2. Verfahren zum Binden eines thermoelektrischen Elements an ein elektrisches Verbindungselement, wobei das Verfahren umfasst:
Bereitstellen eines thermoelektrischen Elements mit einer ersten Schicht darauf, wobei die erste Schicht metallisch ist und einen Schmelzpunkt T1 aufweist;
Bereitstellen eines elektrischen Verbindungselements mit einer zweiten Schicht darauf, wobei die zweite Schicht metallisch ist und einen Schmelzpunkt T2 aufweist;
Aufbringen einer dritten Schicht und Aufeinanderstapeln des thermoelektrischen Elements und des elektrischen Verbindungselements, wobei die dritte Schicht zwischen der ersten Schicht und der zweiten Schicht angeordnet ist, wobei die dritte Schicht metallisch ist, einen Schmelzpunkt T3 aufweist, wenigstens 90 at-% Aluminium umfasst und eine Dicke von wenigstens 10 µm und bis zu 50 µm aufweist;
wobei der Schmelzpunkt T3 niedriger als der Schmelzpunkt T1 und der Schmelzpunkt T2 ist;
Durchführen einer Wärmebehandlung unter Verwendung einer Temperatur, die niedriger als die Temperatur T3 ist, wobei wenigstens 95 at-% des Aluminiums der dritten Schicht mit der ersten Schicht und dem elektrischen Verbindungselement reagieren, um eine oder mehrere intermetallische Verbindungen zu bilden;
Anwenden eines Drucks von bis zu 10 MPa zusätzlich zu der Wärmebehandlung; und
Abkühlen der intermetallischen Verbindung(en), so dass das thermoelektrische Element und das elektrische Verbindungselement miteinander verbunden werden.

3. Verfahren gemäß Anspruch 1 oder Anspruch 2, wobei die dritte Schicht: (i) Aluminium oder eine Aluminiumlegierung ausgewählt aus Legierungen von Aluminium mit Silicium, Kupfer, Magnesium und/oder Mangan umfasst oder im Wesentlichen daraus besteht; und/oder (ii) eine Folie, eine Paste oder ein Pulver umfasst.

4. Verfahren gemäß einem der vorstehenden Ansprüche, wobei bei der Wärmebehandlung eine Temperatur eingesetzt wird, die wenigstens 80 % der Schmelztemperatur T3 beträgt, wobei sowohl die Wärmebehandlungstemperatur als auch T3 in Grad Celsius (°C) gemessen werden.

5. Verfahren gemäß einem der vorstehenden Ansprüche, wobei bei der Wärmebehandlung eine Temperatur von wenigstens 525 °C eingesetzt wird und/oder die Wärmebehandlung für wenigstens 1 Minute und/oder bis zu 300 Minuten durchgeführt wird.

6. Verfahren gemäß einem der vorstehenden Ansprüche, wobei: die erste Schicht Nickel, Ni-P, Ni-B, Ni-P-W, Ni-Cu-P, Ni-P-Ag, Ni-B-P, stromlose Nickelzusammensetzungen, ternäre und quaternäre Nickellegierungen, Nickel-Phosphor- oder Nickel-Bor-Verbundstoffe, Gold, Silber, Kupfer und Titan und deren ternäre und quaternäre Legierungen oder Kombinationen der genannten umfasst oder im Wesentlichen daraus besteht; und/oder das Verfahren einen Anfangsschritt des Aufbringens der ersten Schicht auf das thermoelektrische Element umfasst; oder
Verfahren gemäß Anspruch 2 oder einem der Ansprüche 3 bis 6, wenn abhängig von Anspruch 2, wobei die zweite Schicht Nickel, Ni-P, Ni-B, Ni-P-W, Ni-Cu-P, Ni-P-Ag, Ni-B-P, stromlose Nickelzusammensetzungen, ternäre und quaternäre Nickellegierungen, Nickel-Phosphor- oder Nickel-Bor-Verbundstoffe, Gold, Silber, Kupfer und Titan und deren ternäre und quaternäre Legierungen oder Kombinationen der genannten umfasst oder im Wesentlichen daraus besteht und/oder das Verfahren einen Anfangsschritt des Aufbringens der zweiten Schicht auf das elektrische Verbindungselement umfasst.

7. Verfahren gemäß einem der vorstehenden Ansprüche, wobei: die erste Schicht eine Dicke von wenigstens 0,5 µm und/oder bis zu 200 µm aufweist; oder
Verfahren gemäß Anspruch 2 oder einem der Ansprüche 3 bis 6, wenn abhängig von Anspruch 2, wobei die zweite Schicht eine Dicke von wenigstens 0,5 µm und/oder bis zu 200 µm aufweist und/oder das elektrische Verbindungselement Kupfer umfasst oder im Wesentlichen daraus besteht und die zweite Schicht Nickel oder eine Nickellegierung umfasst oder im Wesentlichen daraus besteht.

8. Verfahren gemäß einem der vorstehenden Ansprüche, wobei das thermoelektrische Element ein oder mehrere thermoelektrische Materialien ausgewählt aus: Bismuttellurid; Bismutselenid; Antimontellurid; Bleitellurid; Bleiselenid; Magnesiumsilicid; Magnesiumstannid; höheres Mangansilicid; Skutteruditmaterialien; Silicide; Half-Heusler-Legierungen; Silicium-Germanium; Oxide und Kombinationen der Genannten umfasst oder im Wesentlichen daraus besteht.

9. Verbindungsstruktur, umfassend ein thermoelektrisches Element und ein elektrisches Verbindungselement mit einer dazwischen angeordneten Bindeschicht, um das thermoelektrische Element und das elektrische Verbindungselement miteinander zu verbinden, wobei die Bindeschicht eine oder mehrere intermetallische Aluminiumverbindungen umfasst, wobei wenigstens 90 at-% des in der Bindeschicht vorhandenen Aluminiums in der Form von intermetallischen Aluminiumverbindung(en) vorliegt und die Bindeschicht eine Dicke von wenigstens 1 µm und bis zu 200 µm aufweist.

10. Verbindungsstruktur gemäß Anspruch 9, wobei die intermetallischen Aluminiumverbindungen intermetallische Verbindungen von Aluminium mit Nickel, Silber, Gold, Kupfer oder Titan umfassen.

11. Verbindungsstruktur gemäß Anspruch 9 oder Anspruch 10, wobei die Bindeschicht eine metallische Schicht in Kontakt mit dem thermoelektrischen Element und/oder eine metallische Schicht in Kontakt mit dem elektrischen Verbindungselement umfasst.

12. Thermoelektrisches Modul oder thermoelektrische Vorrichtung, umfassend eine oder mehrere Verbindungsstrukturen gemäß einem der Ansprüche 9, 10 oder 11.

13. Wärmerückgewinnungssystem, umfassend ein thermoelektrisches Modul oder eine thermoelektrische Vorrichtung gemäß Anspruch 12.

14. Fahrzeug, umfassend ein Wärmerückgewinnungssystem gemäß Anspruch 13.

15. Verwendung eines thermoelektrischen Moduls oder einer thermoelektrischen Vorrichtung gemäß Anspruch 12 zur Erzeugung von elektrischer Energie oder zur Bereitstellung von Kühlung.

## Revendications

1. Procédé pour le collage d'un élément thermoélectrique à une interconnexion électrique, le procédé comprenant :
la fourniture d'un élément thermoélectrique sur lequel se trouve une première couche, la première couche étant métallique et ayant un point de fusion T1 ;
la fourniture de (i) une interconnexion électrique ayant un point de fusion T2 ;
l'application d'une troisième couche et l'empilement de l'élément thermoélectrique et de l'interconnexion électrique l'un sur l'autre de façon à ce que la troisième couche soit disposée (i) entre la première couche et l'interconnexion électrique, la troisième couche étant métallique, ayant un point de fusion T3, comprenant au moins 90 % at. d'aluminium et ayant une épaisseur d'au moins 10 µm et allant jusqu'à 50 µm ;
dans lequel le point de fusion T3 est plus bas que point de fusion T1 et que le point de fusion T2 ;
la mise en œuvre d'un traitement thermique employant une température qui est inférieure à la température T3, dans lequel au moins 95 % at. de l'aluminium provenant de la troisième couche réagit avec la première couche et l'interconnexion électrique pour former un ou plusieurs composés intermétalliques ;
l'application d'une pression allant jusqu'à 10 MPa en plus du traitement thermique ; et
le refroidissement du ou des composés intermétalliques de façon telle que l'élément thermoélectrique et l'interconnexion électrique sont collés l'un à l'autre.

2. Procédé pour le collage d'un élément thermoélectrique à une interconnexion électrique, le procédé comprenant :
la fourniture d'un élément thermoélectrique sur lequel se trouve une première couche, la première couche étant métallique et ayant un point de fusion T1 ;
la fourniture d'une interconnexion électrique sur laquelle se trouve une deuxième couche, la deuxième couche étant métallique et ayant un point de fusion T2 ;
l'application d'une troisième couche et l'empilement de l'élément thermoélectrique et de l'interconnexion électrique l'un sur l'autre de façon à ce que la troisième couche soit disposée entre la première couche et la deuxième couche, la troisième couche étant métallique, ayant un point de fusion T3, comprenant au moins 90 % at. d'aluminium et ayant une épaisseur d'au moins 10 µm et allant jusqu'à 50 µm ;
dans lequel le point de fusion T3 est plus bas que le point de fusion T1 et que le point de fusion T2 ;
la mise en œuvre d'un traitement thermique employant une température qui est inférieure à la température T3, dans lequel au moins 95 % at. de l'aluminium provenant de la troisième couche réagit avec la première couche et l'interconnexion électrique pour former un ou plusieurs composés intermétalliques ;
l'application d'une pression allant jusqu'à 10 MPa en plus du traitement thermique ; et
le refroidissement du ou des composés intermétalliques de façon telle que l'élément thermoélectrique et l'interconnexion électrique sont collés l'un à l'autre.

3. Procédé selon la revendication 1 ou la revendication 2, dans lequel la troisième couche : (i) comprend, ou est constituée essentiellement de celui-ci, de l'aluminium ou un alliage d'aluminium choisi parmi les alliages d'aluminium avec du silicium, du cuivre, du magnésium et/ou du manganèse ; et/ou (ii) comprend une feuille, une pâte ou une poudre.

4. Procédé selon l'une quelconque des revendications précédentes, dans lequel le traitement thermique emploie une température qui est d'au moins 80 % de la température du point de fusion T3, aussi bien la température de traitement thermique que T3 étant mesurées en degrés Celsius (°C).

5. Procédé selon l'une quelconque des revendications précédentes, dans lequel le traitement thermique emploie une température d'au moins 525 °C et/ou le traitement thermique est mis en œuvre pendant au moins 1 minute et/ou jusqu'à 300 minutes.

6. Procédé selon l'une quelconque des revendications précédentes, dans lequel : la première couche comprend, ou est constituée essentiellement de ceux-ci, du nickel, Ni-P, Ni-B, Ni-P-W, Ni-Cu-P, Ni-P-Ag, Ni-B-P, des compositions de dépôt autocatalytique de nickel, des alliages ternaires et quaternaires de nickel, des composites de nickel-phosphore ou de nickel-bore, de l'or, de l'argent, du cuivre et du titane et leurs alliages ternaires et quaternaires ou des combinaisons de ceux-ci ; et/ou le procédé comprend une étape initiale consistant à appliquer la première couche sur l'élément thermoélectrique ; ou
procédé selon la revendication 2, ou l'une quelconque des revendications 3 à 6 lorsqu'elles sont dépendantes de la revendication 2, dans lequel la deuxième couche comprend, ou est constituée essentiellement de ceux-ci, du nickel, Ni-P, Ni-B, Ni-P-W, Ni-Cu-P, Ni-P-Ag, Ni-B-P, des compositions de dépôt autocatalytique de nickel, des alliages ternaires et quaternaires de nickel, des composites de nickel-phosphore ou de nickel-bore, de l'or, de l'argent, du cuivre et du titane et leurs alliages ternaires et quaternaires ou des combinaisons de ceux-ci ; et/ou le procédé comprend une étape initiale consistant à appliquer la deuxième couche sur l'interconnexion électrique.

7. Procédé selon l'une quelconque des revendications précédentes, dans lequel : la première couche a une épaisseur d'au moins 0,5 µm et/ou allant jusqu'à 200 µm ; ou
procédé selon la revendication 2, ou l'une quelconque des revendications 3 à 6 lorsqu'elles sont dépendantes de la revendication 2, dans lequel la deuxième couche a une épaisseur d'au moins 0,5 µm et/ou allant jusqu'à 200 µm et/ou l'interconnexion électrique comprend, ou est constituée essentiellement de celui-ci, du cuivre et la deuxième couche comprend, ou est constituée essentiellement de celui-ci, du nickel ou un alliage de nickel.

8. Procédé selon l'une quelconque des revendications précédentes, dans lequel l'élément thermoélectrique comprend, ou est constitué essentiellement de ceux-ci, un ou plusieurs matériaux thermoélectriques choisis parmi : le tellurure de bismuth ; le séléniure de bismuth ; le tellurure d'antimoine ; le tellurure de plomb ; le séléniure de plomb ; le siliciure de magnésium ; le stannure de magnésium ; le siliciure de manganèse supérieur ; des matériaux skuttérudites ; des siliciures ; des alliages demi-Heusler ; le silicium-germanium, des oxydes et des combinaisons de ceux-ci.

9. Structure de collage comprenant un élément thermoélectrique et une interconnexion électrique ayant une couche de collage disposée entre eux de manière à coller l'élément thermoélectrique et l'interconnexion électrique l'un à l'autre, la couche de collage comprenant un ou plusieurs composés intermétalliques de l'aluminium, dans laquelle au moins 90 % at. de l'aluminium présent dans la couche de collage est présent sous la forme d'un ou plusieurs composés intermétalliques de l'aluminium et la couche de collage a une épaisseur d'au moins 1 µm et allant jusqu'à 200 µm.

10. Structure de collage selon la revendication 9, dans laquelle les composés intermétalliques de l'aluminium comprennent des composés intermétalliques de l'aluminium avec du nickel, de l'argent, de l'or, du cuivre ou du titane.

11. Structure de collage selon la revendication 9 ou la revendication 10, dans laquelle la couche de collage comprend une couche métallique en contact avec l'élément thermoélectrique et/ou une couche métallique en contact avec l'interconnexion électrique.

12. Module thermoélectrique ou dispositif thermoélectrique comprenant une ou plusieurs structures de collage selon l'une quelconque des revendications 9, 10 ou 11.

13. Système de récupération de chaleur comprenant un module thermoélectrique ou un dispositif thermoélectrique selon la revendication 12.

14. Véhicule comprenant un système de récupération de chaleur selon la revendication 13.

15. Utilisation d'un module thermoélectrique ou d'un dispositif thermoélectrique selon la revendication 12 pour générer de l'énergie électrique ou pour assurer un refroidissement.
